# EUROPEAN PATENT APPLICATION

(11) **EP 4 669 064 A1**
(43) Date of publication of application: **24.12.2025**
(21) Application number: 25177626.6
(22) Date of filing: 20.05.2025
(51) Int. Cl.: H10H 20/816, H10H 20/821

(54) **LIGHT-EMITTING ELEMENT, DISPLAY DEVICE INCLUDING THE LIGHT-EMITTING ELEMENT, AND METHOD FOR MANUFACTURING THE LIGHT-EMITTING ELEMENT**

(30) Priority: 14.06.2024 KR 20240077417
(71) Applicant: Samsung Display Co., Ltd., Yongin-si, Gyeonggi-do 17113 (KR)
(72) Inventor: LEE, Sang Tae, 17113 Yongin-si (KR); HEO, Jeong Hun, 17113 Yongin-si (KR); KIM, Jun Youn, 17113 Yongin-si (KR); LEE, Kwan Jae, 17113 Yongin-si (KR)
(74) Representative: Walaski, Jan Filip

(57) **Abstract**

A light-emitting element includes a p-type semiconductor layer including a groove, a first insulating layer disposed on the p-type semiconductor layer around the groove, a light-emitting layer disposed in the groove and having a side surface surrounded by the p-type semiconductor layer and the first insulating layer, and an n-type semiconductor layer disposed on the light-emitting layer.

## Description

This application claims priority to Korean Patent Application No. 10-2024-0077417, filed on 14 June 2024.

### BACKGROUND

### 1. Field

The invention relates to a light-emitting element, and more particularly to a light-emitting element, a display device including the light-emitting element, and a method for manufacturing the light-emitting element.

### 2. Description of the Related Art

The importance of display devices has steadily increased with the development of multimedia technology. Along with this trend, various types of display devices such as a liquid crystal display device, a light-emitting display device and the like have been developed. A light-emitting display device using a dual light-emitting element is applied to various types of electronic devices, such as virtual reality (VR) devices or augmented reality (AR) devices as well as portable electronic devices or television sets.

### SUMMARY

Aspects of the invention provide a light-emitting element with improved luminous efficiency, a display device including the same, and a method for manufacturing the light-emitting element.

However, the invention is not restricted or limited to those set forth herein. The above and other aspects of the invention will become more apparent to one of ordinary skill in the art to which the invention pertains by referencing the detailed description of the disclosure given below.

According to an aspect of the invention, there is provided a light-emitting element including, a p-type semiconductor layer including a groove, a first insulating layer disposed on the p-type semiconductor layer around the groove, a light-emitting layer disposed in the groove, and having a side surface surrounded by the p-type semiconductor layer and the first insulating layer, and an n-type semiconductor layer disposed on the light-emitting layer.

In an embodiment, the light-emitting layer may include an upper portion protruding above the p-type semiconductor layer and surrounded by the first insulating layer, and a remaining portion of the light-emitting layer except that the upper portion may be completely surrounded by the p-type semiconductor layer.

In an embodiment, the light-emitting layer may include quantum well layers and barrier layers alternately arranged on the p-type semiconductor layer, wherein the quantum well layers may be disposed at a height less than or equal to a height of the p-type semiconductor layer.

In an embodiment, the light-emitting layer may include quantum well layers and barrier layers alternately arranged on the p-type semiconductor layer, wherein side surfaces of the quantum well layers may be completely surrounded by the p-type semiconductor layer.

In an embodiment, the n-type semiconductor layer may include an edge portion overlapping the p-type semiconductor layer, wherein the first insulating layer may be interposed between the p-type semiconductor layer and the n-type semiconductor layer at a portion where the p-type semiconductor layer and the n-type semiconductor layer overlap.

In an embodiment, the first insulating layer may include a first opening overlapping the groove and a second opening exposing a part of the p-type semiconductor layer, wherein the light-emitting element may further include a first electrode positioned in the second opening and connected to the p-type semiconductor layer.

In an embodiment, the light-emitting element may further include a second electrode connected to the n-type semiconductor layer.

In an embodiment, the light-emitting element may further include a contact electrode disposed on the n-type semiconductor layer and connected between the n-type semiconductor layer and the second electrode.

In an embodiment, the light-emitting element may further include a second insulating layer disposed on the first insulating layer and surrounding a side surface of the n-type semiconductor layer.

In an embodiment, the second electrode may be disposed on the second insulating layer.

In an embodiment, the light-emitting element may further include at least two grooves including the groove, and formed in the p-type semiconductor layer to be spaced apart from each other, at least two light-emitting layers including the light-emitting layer, and disposed in the at least two grooves to be spaced apart from each other, and at least two n-type semiconductor layers including the n-type semiconductor layer, and disposed on the at least two light-emitting layers which are disposed to be spaced apart from each other.

In an embodiment, the first insulating layer may include at least two openings corresponding to the at least two grooves, wherein the first insulating layer may surround an upper portion of each of the at least two light-emitting layers.

In an embodiment, the light-emitting element may further include a second insulating layer disposed on the first insulating layer, and surrounding side surfaces of the at least two n-type semiconductor layers.

According to an aspect of the invention, there is provided a display device including a pixel including a first pixel electrode, a second pixel electrode, and a light-emitting element connected between the first pixel electrode and the second pixel electrode. The light-emitting element may include, a p-type semiconductor layer including a groove, a first insulating layer disposed on the p-type semiconductor layer around the groove, a light-emitting layer disposed in the groove and having a side surface surrounded by the p-type semiconductor layer and the first insulating layer, and an n-type semiconductor layer disposed on the light-emitting layer.

In an embodiment, the light-emitting layer may include an upper portion protruding above the p-type semiconductor layer and surrounded by the first insulating layer, and a remaining portion of the light-emitting layer except that the upper portion may be completely surrounded by the p-type semiconductor layer.

In an embodiment, the light-emitting layer may include quantum well layers and barrier layers alternately arranged on the p-type semiconductor layer, wherein side surfaces of the quantum well layers may be completely surrounded by the p-type semiconductor layer.

In an embodiment, the n-type semiconductor layer may include an edge portion overlapping the p-type semiconductor layer, wherein the first insulating layer may be interposed between the p-type semiconductor layer and the n-type semiconductor layer at a portion where the p-type semiconductor layer and the n-type semiconductor layer overlap.

According to an aspect of the invention, there is provided a method for manufacturing a light-emitting element, including, forming a p-type semiconductor layer on a substrate, forming a first insulating layer on the p-type semiconductor layer, forming a first opening in the first insulating layer to expose a part of the p-type semiconductor layer, etching the part of the p-type semiconductor layer to a certain thickness to form a groove in the p-type semiconductor layer, forming a light-emitting layer in the groove, and forming an n-type semiconductor layer on the light-emitting layer.

In an embodiment, the method may further include, forming a second opening in the first insulating layer to expose another part of the p-type semiconductor layer, at a location spaced from the groove, and forming a first electrode on another part of the p-type semiconductor layer.

In an embodiment, the method may further include, forming a contact electrode on the n-type semiconductor layer, forming a second insulating layer covering a side surface of the n-type semiconductor layer on the first insulating layer, and forming a second electrode connected to the contact electrode, on the contact electrode and the second insulating layer.

In an embodiment and in accordance with the light-emitting element and the method for manufacturing the same, a groove is formed in a p-type semiconductor layer, and a light-emitting layer is disposed in the groove, so that the light-emitting layer may be surrounded by the p-type semiconductor layer. In accordance with an embodiment, non-emission recombination due to surface defects may be prevented or reduced by suppressing or reducing the occurrence of surface defects of a light-emitting element, and the amount of holes injected into the light-emitting layer may be increased. Accordingly, the luminous efficiency of the light-emitting element may be improved.

In an embodiment and in accordance with the light-emitting element and the method for manufacturing the same, the light-emitting layer may protrude above the p-type semiconductor layer, and the upper portion of the light-emitting layer may be surrounded by a first insulating layer disposed on the p-type semiconductor layer. In accordance with an embodiment, contact between the p-type semiconductor layer and an n-type semiconductor layer may be stably prevented, and the luminous efficiency of the light-emitting element may be further improved.

In an embodiment, the light-emitting layer may include a barrier layer and a quantum well layer, wherein the side surface of the quantum well layer may be completely surrounded by the p-type semiconductor layer. Accordingly, the amount of holes injected into the quantum well layer may be effectively increased.

A display device according to an embodiment may include a pixel including the light-emitting element. Accordingly, the luminous efficiency of the pixel and the display device including the same may be improved.

However, effects according to embodiments of the invention are not limited to those exemplified above and various other effects are incorporated herein.

### BRIEF DESCRIPTION OF THE DRAWINGS

The above and other aspects and features of the invention will become more apparent by describing in detail embodiments thereof with reference to the attached drawings, in which:
FIG. 1 is a perspective view illustrating a light-emitting element;
FIG. 2 is a cross-sectional view illustrating the light-emitting element;
FIG. 3 is a cross-sectional view illustrating the light-emitting element;
FIG. 4 is an enlarged cross-sectional view of area A1 of the light-emitting element of FIG. 3;
FIG. 5 is a plan view showing the arrangement shape of the light-emitting layer and the first insulating layer;
FIG. 6 is a cross-sectional view showing a light-emitting element substrate including the light-emitting elements;
FIG. 7 is a cross-sectional view showing the light-emitting element substrate including the light-emitting elements;
FIG. 8 is a cross-sectional view showing a method for manufacturing the light-emitting element;
FIG. 9 is a cross-sectional view showing a method for manufacturing the light-emitting element;
FIG. 10 is a cross-sectional view showing a method for manufacturing the light-emitting element;
FIG. 11 is a cross-sectional view showing a method for manufacturing the light-emitting element;
FIG. 12 is a cross-sectional view showing a method for manufacturing the light-emitting element;
FIG. 13 is a cross-sectional view showing a method for manufacturing the light-emitting element;
FIG. 14 is a cross-sectional view showing a method for manufacturing the light-emitting element;
FIG. 15 is a cross-sectional view showing a method for manufacturing the light-emitting element;
FIG. 16 is a cross-sectional view showing a method for manufacturing the light-emitting element;
FIG. 17 is a perspective view illustrating a display device;
FIG. 18 is a plan view showing an example of area A2 of the display device of FIG. 17;
FIG. 19 is a cross-sectional view illustrating the display panel;
FIG. 20 is a cross-sectional view illustrating the display panel;
FIG. 21 is a cross-sectional view illustrating the display panel;
FIG. 22 is a cross-sectional view illustrating the display panel;
FIG. 23 is a diagram illustrating a virtual reality device including a display device;
FIG. 24 is a diagram illustrating a smart device including a display device;
FIG. 25 illustrates an automobile dashboard and center fascia including display devices; and
FIG. 26 is a diagram illustrating a transparent display device including a display device.

### DETAILED DESCRIPTION OF THE EMBODIMENTS

The invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when an element or a layer is referred to as being "on" another element or layer, it can be directly on the other element or layer, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present invention. Similarly, the second element could also be termed the first element.

Features of each of various embodiments of the invention may be partially or entirely combined with each other and may technically variously interwork with each other, and respective embodiments may be implemented independently of each other or may be implemented together in association with each other.

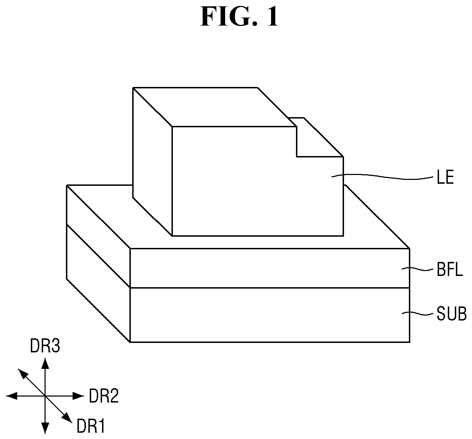

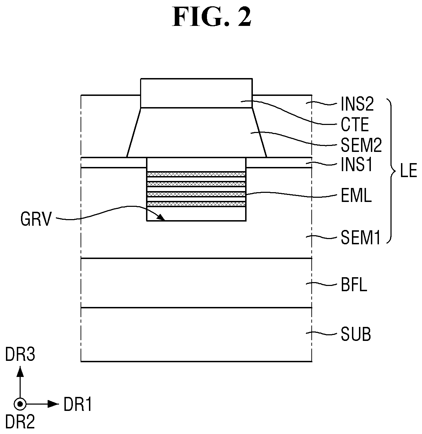

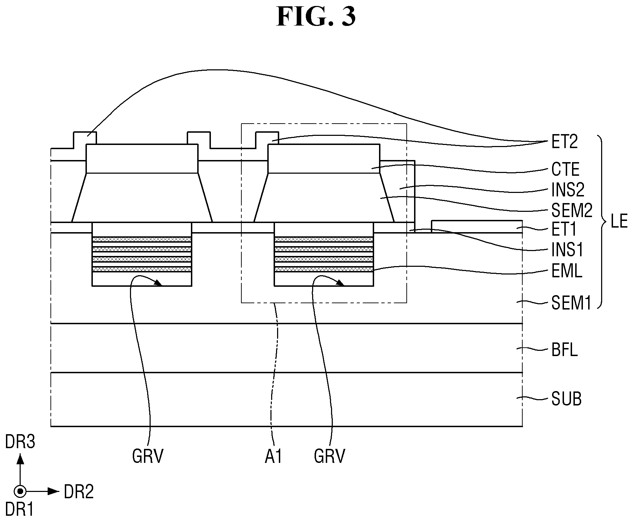

FIG. 1 is a perspective view illustrating a light-emitting element LE. FIG. 2 is a cross-sectional view illustrating the light-emitting element LE. FIG. 3 is a cross-sectional view illustrating the light-emitting element LE. For example, FIG. 1 shows a schematic shape of the light-emitting element LE along a first direction DR1, a second direction DR2, and a third direction DR3, and FIGS. 2 and 3 show cross sections of the light-emitting element LE along the first direction DR1 and the second direction DR2, respectively.

Although FIGS. 1 to 3 illustrate a state in which the light-emitting element LE is disposed on a substrate SUB, the invention is not limited thereto. For example, the light-emitting element LE may be manufactured on the substrate SUB and then separated from the substrate SUB. Further, although FIGS. 1 to 3 illustrate that only one light-emitting element LE is disposed on the substrate SUB, the invention is not limited thereto. For example, a plurality of light-emitting elements LE may be disposed on the substrate SUB.

Referring to FIGS. 1 to 3, the light-emitting element LE may be disposed on the substrate SUB. A buffer layer BFL may be disposed on the substrate SUB, and the light-emitting element LE may be disposed on the buffer layer BFL.

The light-emitting element LE may have a substantially rectangular shape in a plan view or a cross-sectional view (e.g., transverse or longitudinal cross-sectional view), and may have a staircase shape in which a height of one portion is different from a height of another portion. However, the shape of the light-emitting element LE is not limited to the shape shown in FIGS. 1 to 3, and may be variously changed. For example, the planar shape or the cross-sectional shape of the light-emitting element LE or a light-emitting layer EML of the light-emitting element LE may be variously changed. For example, the light-emitting element LE or the light-emitting layer EML may have a polygonal shape other than a quadrilateral shape, a circular shape, or another shape in a plan view or a cross-sectional view. Further, although FIGS. 1 to 3 illustrate an example in which the light-emitting element LE and the light-emitting layer EML have side surfaces which are substantially perpendicular to the substrate SUB, the invention is not limited thereto. For example, the light-emitting element LE or the light-emitting layer EML may have an inclined side surface inclined in a diagonal direction with respect to the substrate SUB.

The first direction DR1, the second direction DR2, and the third direction DR3 shown in FIGS. 1 to 3 may be directed perpendicular to each other. For example, the first direction DR1 and the second direction DR2 may be directed perpendicular to each other, and may define a plane that is directed parallel to the main surface (e.g., the top surface) of the substrate SUB. The third direction DR3 may be directed perpendicular to the first direction DR1 and the second direction DR2. For example, the third direction DR3 may be a direction that is directed perpendicular to the main surface of the substrate SUB and may be a height direction or a thickness direction of the substrate SUB or the light-emitting element LE.

The light-emitting element LE may be an inorganic light-emitting element made of an inorganic material. For example, the light-emitting element LE may be an inorganic light-emitting diode formed of a nitride-based semiconductor material (e.g., GaN, AlGaN, GaAlN, InGaN, AlInGaN, AIN, InN, or another nitride-based semiconductor material), a phosphide-based semiconductor material (e.g., GaP, GaInP, AlGaP, AlInP, AlGaInP, AlP, InP or another phosphide-based semiconductor material), or another inorganic material. The light-emitting element LE may be formed of a nitride-based semiconductor material including GaN and InGaN and may emit light of a specific color (e.g., red light, green light, or blue light). The material forming the light-emitting element LE and the color or wavelength of light emitted from the light-emitting element LE may vary.

The light-emitting element LE may be a micro light-emitting diode (micro LED) having a small size in the micrometer (µm) range. For example, the light-emitting element LE may be a micro LED having a length (e.g., horizontal or vertical length) in the first direction DR1, a length (e.g., vertical or horizontal length) in the second direction DR2, and a length (e.g., thickness or height) in the third direction DR3, which are several to hundreds of micrometers, respectively. Each of the length of the light-emitting element LE in the first direction DR1, the length in the second direction DR2, and the length in the third direction DR3 may be approximately 100 µm or less. However, the size of the light-emitting element LE is not limited thereto, and the light-emitting element LE may be manufactured in various sizes.

The light-emitting element LE may include a p-type semiconductor layer SEM1 (also referred to as "first semiconductor layer"), the light-emitting layer EML (also referred to as "active layer"), and an n-type semiconductor layer SEM2 (also referred to as "second semiconductor layer") that are sequentially disposed on the substrate SUB. For example, the p-type semiconductor layer SEM1, the light-emitting layer EML, and the n-type semiconductor layer SEM2 may be sequentially disposed on the buffer layer BFL (or the substrate SUB) along the third direction DR3. The p-type semiconductor layer SEM1 may include a groove GRV (e.g., a groove or a recess), and the light-emitting layer EML may be disposed in the groove GRV of the p-type semiconductor layer SEM1 to be surrounded by at least the p-type semiconductor layer SEM1.

The light-emitting element LE may include at least two grooves GRV formed in the p-type semiconductor layer SEM1 to be spaced apart from each other, and at least two light-emitting layers EML disposed in and/or above the respective grooves GRV and spaced apart from each other. Further, the light-emitting element LE may include at least two n-type semiconductor layers SEM2 disposed on the at least two light-emitting layers EML and spaced apart from each other. However, the number of grooves GRV, the number of light-emitting layers EML, and the number of n-type semiconductor layers SEM2 of the p-type semiconductor layer SEM1 that are provided in the light-emitting element LE are not particularly limited, and may be variously changed. For example, the light-emitting element LE may include at least one groove GRV formed in the p-type semiconductor layer SEM1, at least one light-emitting layer EML disposed in and/or above the groove GRV, and at least one n-type semiconductor layer SEM2 disposed on the light-emitting layer EML.

The light-emitting element LE may further include a first insulating layer INS1, a second insulating layer INS2, and a contact electrode CTE. The light-emitting element LE may include a plurality of contact electrodes CTE individually disposed on the plurality of n-type semiconductor layers SEM2. The light-emitting element LE may further include at least one of a first electrode ET1 or a second electrode ET2.

Although FIGS. 2 and 3 illustrate an example in which the light-emitting element LE includes the contact electrode CTE, the first electrode ET1, and the second electrode ET2, the invention is not limited thereto. For example, at least one of the contact electrode CTE, the first electrode ET1, or the second electrode ET2 may be formed separately from the light-emitting element LE and may be in contact with or connected (e.g., electrically connected) to the light-emitting element LE. The light-emitting element LE may include only one of the contact electrode CTE and the second electrode ET2.

The substrate SUB (also referred to as "growth substrate" or "manufacturing substrate") may be a semiconductor substrate used for manufacturing the light-emitting element LE. The substrate SUB may be a wafer or a manufacturing substrate suitable for epitaxial growth. For example, the p-type semiconductor layer SEM1, the light-emitting layer EML, and the n-type semiconductor layer SEM2 of the light-emitting element LE may be formed on the substrate SUB by epitaxial growth.

The substrate SUB may be a substrate containing a material such as GaAs, silicon (Si), sapphire, SiC, GaN, or ZnO. As an example, the substrate SUB may be a silicon or sapphire substrate. When epitaxial growth for manufacturing the light-emitting element LE may be performed smoothly, the type or material of the substrate SUB is not particularly limited. The substrate SUB may be used as a substrate for epitaxial growth for manufacturing the light-emitting element LE and then may be finally separated from the light-emitting element LE. For example, after forming the plurality of light-emitting elements LE through epitaxial growth on the substrate SUB at the same time, the light-emitting elements LE may be separated from the substrate SUB.

The buffer layer BFL may be disposed on the substrate SUB and may be formed to reduce the lattice constant difference between the p-type semiconductor layer SEM1 and the substrate SUB. The buffer layer BFL may include an undoped semiconductor material. For example, the buffer layer BFL may be an undoped semiconductor layer containing a nitride-based semiconductor material or a phosphide-based semiconductor material. For example, the buffer layer BFL may be a single-layer or multilayer semiconductor layer containing undoped GaN, AlGaN, InGaN, InAlGaN, AIN, InN, or another nitride-based semiconductor material.

The p-type semiconductor layer SEM1 may be disposed on the substrate SUB and may contain a semiconductor material doped with a p-type dopant. For example, the p-type semiconductor layer SEM1 may contain a nitride-based semiconductor material or a phosphide-based semiconductor material, and may further contain a p-type dopant such as Mg, Zn, Ca, Se, Ba, or the like. The p-type semiconductor layer SEM1 may contain GaN (e.g., p-GaN) doped with the p-type dopant, but the material of the p-type semiconductor layer SEM1 is not limited thereto.

The p-type semiconductor layer SEM1 may include at least one groove GRV, and the light-emitting layer EML may be disposed in each groove GRV. Accordingly, the p-type semiconductor layer SEM1 may surround the light-emitting layer EML. For example, the p-type semiconductor layer SEM1 may cover the surface of the light-emitting layer EML, including the bottom surface and the side surface (or a part of the side surface) of the light-emitting layer EML. The p-type semiconductor layer SEM1 may be in direct contact with the light-emitting layer EML.

The groove GRV may include a vertical sidewall extending in the third direction DR3. However, the shape of the groove GRV is not limited thereto. For example, the groove GRV may include an inclined sidewall inclined with respect to the third direction DR3. The shape or size of the groove GRV may be variously changed.

The light-emitting layer EML may be disposed on the p-type semiconductor layer SEM1. For example, the light-emitting layer EML may be directly disposed on a part of the p-type semiconductor layer SEM1 to be in contact with the p-type semiconductor layer SEM1.

The light-emitting layer EML may be disposed on the p-type semiconductor layer SEM1 while being surrounded by the p-type semiconductor layer SEM1. For example, the light-emitting layer EML may be disposed in and/or above the groove GRV formed in the p-type semiconductor layer SEM1. For example, at least a part of the light-emitting layer EML may be disposed in the groove GRV (e.g., above the bottom surface of the groove GRV) of the p-type semiconductor layer SEM1, and may be surrounded or covered by the p-type semiconductor layer SEM1.

The light-emitting layer EML may be formed to have a height greater than or equal to the height of the p-type semiconductor layer SEM1, and the side surface of the light-emitting layer EML may be surrounded or covered by the p-type semiconductor layer SEM1 and the first insulating layer INS1 on the p-type semiconductor layer SEM1. For example, the light-emitting layer EML may include an upper portion protruding above the p-type semiconductor layer SEM1, and the upper portion of the light-emitting layer EML may be surrounded or covered by the first insulating layer INS1 disposed around the groove GRV. The remaining portion of the light-emitting layer EML, except the upper portion, may be completely surrounded or covered by the p-type semiconductor layer SEM1.

The light-emitting layer EML may be interposed between the p-type semiconductor layer SEM1 and the n-type semiconductor layer SEM2. The light-emitting layer EML may emit light by recombination of electron-hole pairs according to an electrical signal applied through the p-type semiconductor layer SEM1 and the n-type semiconductor layer SEM2.

The light-emitting layer EML may include a nitride-based semiconductor material, a phosphide-based semiconductor material, or another semiconductor material, and may have a single or a multiple quantum well structure. The light-emitting layer EML may contain at least one of GaN or InGaN and may have a multiple quantum well structure. For example, the light-emitting layer EML may include a quantum well layer containing InGaN, and a barrier layer containing GaN, AlGaN, or GaAlN. When the light-emitting layer EML contains InGaN, the color of light emitted from the light-emitting layer EML may vary depending on the content of indium (In). For example, as the content of indium (In) increases, the wavelength band of the light emitted by the light-emitting layer EML may shift to the red wavelength band, and as the content of indium (In) decreases, the wavelength band of the light emitted by the light-emitting layer EML may shift to the blue wavelength band. The material or structure of the light-emitting layer EML may be variously changed.

The first insulating layer INS1 may be disposed on the p-type semiconductor layer SEM1, and may surround the groove GRV. For example, the first insulating layer INS1 may be disposed on the p-type semiconductor layer SEM1 around the groove GRV, and may have an opening corresponding to the groove GRV.

The first insulating layer INS1 may cover a part of the p-type semiconductor layer SEM1, and may expose another part of the p-type semiconductor layer SEM1. For example, the first insulating layer INS1 may expose the p-type semiconductor layer SEM1 at least in the area where the groove GRV is formed. The first insulating layer INS1 may be opened to expose a part of the p-type semiconductor layer SEM1 at a position that is spaced apart from the groove GRV. The first electrode ET1 may be disposed on the exposed part of the p-type semiconductor layer SEM1.

The first insulating layer INS1 may cover a part of the side surface of the light-emitting layer EML. For example, the upper portion of the light-emitting layer EML that protrudes above the p-type semiconductor layer SEM1 may be surrounded by the side surface of the first insulating layer INS1. Due to the first insulating layer INS1, the contact (e.g., direct contact) or bonding between the p-type semiconductor layer SEM1 and the n-type semiconductor layer SEM2 may be stably prevented, and the electrical stability of the light-emitting element LE may be ensured.

The p-type semiconductor layer SEM1 may include at least two grooves GRV that are separated or spaced apart from each other, and the first insulating layer INS1 may include at least two openings corresponding to the at least two grooves GRV. Further, the first insulating layer INS1 may surround or cover the upper portion of each of at least two light-emitting layers EML disposed in the at least two grooves GRV.

The first insulating layer INS1 may include at least one insulating material among silicon oxide (SiOₓ) (e.g., SiO₂), silicon nitride (SiNₓ) (e.g., Si₃N₄), aluminum oxide (AlₓO_{y}) (e.g., Al₂O₃), titanium oxide (TiₓO_{y}) (e.g., TiO₂), and hafnium oxide (HfOₓ), or another insulating material. The first insulating layer INS1 may include a material suitable for use as a mask in a process of forming the groove GRV in the p-type semiconductor layer SEM1, but is not limited thereto.

The n-type semiconductor layer SEM2 may be disposed on the light-emitting layer EML. For example, the n-type semiconductor layer SEM2 may be disposed directly on the light-emitting layer EML. The n-type semiconductor layer SEM2 may have a width greater than that of the light-emitting layer EML. For example, the n-type semiconductor layer SEM2 may include a central portion overlapping the light-emitting layer EML, and an edge portion overlapping the p-type semiconductor layer SEM1 around the light-emitting layer EML. At the portion where the p-type semiconductor layer SEM1 and the n-type semiconductor layer SEM2 overlap, the first insulating layer INS1 may be interposed between the p-type semiconductor layer SEM1 and the n-type semiconductor layer SEM2. For example, the first insulating layer INS1 may be disposed between the edge portion of the n-type semiconductor layer SEM2 and the p-type semiconductor layer SEM1, thereby preventing direct contact between the p-type semiconductor layer SEM1 and the n-type semiconductor layer SEM2.

The n-type semiconductor layer SEM2 may contain a semiconductor material doped with an n-type dopant. For example, the n-type semiconductor layer SEM2 may contain a nitride-based semiconductor material or a phosphide-based semiconductor material, and may further contain an n-type dopant such as Si, Ge, Sn, or the like. The n-type semiconductor layer SEM2 may contain GaN (e.g., n-GaN) doped with the n-type dopant, but the material of the n-type semiconductor layer SEM2 is not limited thereto.

The contact electrode CTE may be disposed on the n-type semiconductor layer SEM2 and may protect the n-type semiconductor layer SEM2 and smoothly connect the n-type semiconductor layer SEM2 to at least one electrode, circuit element, or wire, or the like. The contact electrode CTE may be connected between the n-type semiconductor layer SEM2 and the second electrode ET2.

The contact electrode CTE may include a metal, a metal oxide, or another conductive material. The contact electrode CTE may be formed as a transparent electrode layer containing a transparent conductive material. Accordingly, light generated from the light-emitting layer EML may transmit through the contact electrode CTE.

The second insulating layer INS2 may be disposed on the first insulating layer INS1. The second insulating layer INS2 may surround or cover the side surface of the n-type semiconductor layer SEM2, and may protect the n-type semiconductor layer SEM2. The second insulating layer INS2 may further cover at least a part of the contact electrode CTE. For example, the second insulating layer INS2 may be formed to have a height greater than that of the n-type semiconductor layer SEM2, and may cover a part of the side surface of the contact electrode CTE.

The second insulating layer INS2 may be a single-layer or a multilayer insulating layer containing at least one insulating material. The second insulating layer INS2 may include an organic insulating layer containing at least one organic insulating material, and may flatten one surface of the light-emitting element LE where the n-type semiconductor layer SEM2 or the like is disposed.

The p-type semiconductor layer SEM1 may include at least two grooves GRV that are separated or spaced apart from each other, where the second insulating layer INS2 may surround or cover the side surfaces of at least two n-type semiconductor layers SEM2 disposed on the light-emitting layers EML disposed in the at least two grooves GRV.

The first electrode ET1 may be disposed on the p-type semiconductor layer SEM1, and may be connected (e.g., electrically connected) to the p-type semiconductor layer SEM1. For example, the first electrode ET1 may be directly disposed on a part of the p-type semiconductor layer SEM1 that is exposed in the area where the first insulating layer INS1 and the second insulating layer INS2 are opened, and may be connected to the p-type semiconductor layer SEM1. The first electrode ET1 may include at least one conductive material (e.g., a metal, a metal oxide, or another conductive material).

The second electrode ET2 may be disposed on the contact electrode CTE and the second insulating layer INS2, and may be connected (e.g., electrically connected) to the n-type semiconductor layer SEM2. For example, the second electrode ET2 may be disposed on a part of each of the contact electrode CTE and the second insulating layer INS2, and may be electrically connected to the n-type semiconductor layer SEM2 through the contact electrode CTE. The second electrode ET2 may include at least one conductive material. The first electrode ET1 and the second electrode ET2 may include the same conductive material, but are not limited thereto.

The first electrode ET1 and the second electrode ET2 may be disposed on the top surface of the light-emitting element LE, and may be located at different heights on the substrate SUB. However, the invention is not limited thereto. For example, the first electrode ET1 and the second electrode ET2 may be disposed on different surfaces of the light-emitting element LE to face each other, or the light-emitting element LE may not include at least one of the first electrode ET1 or the second electrode ET2. For example, the light-emitting element LE may not include the second electrode ET2, and the contact electrode CTE of the light-emitting element LE may be directly connected to a pixel electrode provided on a backplane substrate of a display panel.

The groove GRV is formed in the p-type semiconductor layer SEM1, and the light-emitting layer EML is disposed in the groove GRV, so that the light-emitting layer EML may be surrounded or covered by the p-type semiconductor layer SEM1. Non-luminous recombination due to surface defects may be prevented by suppressing or reducing the occurrence of surface defects (e.g., surface level) of the light-emitting element LE, and the amount of holes injected into the light-emitting layer EML may be increased. For example, since the side surface of the light-emitting layer EML is surrounded or covered by the p-type semiconductor layer SEM1, the crystal bonding of the light-emitting element LE may be improved, and holes whose moving distance is shorter than that of electrons may be smoothly injected into the light-emitting layer EML. Accordingly, the emission combination of holes and electrons may be increased, and the luminous efficiency of the light-emitting element LE may be improved.

The light-emitting element LE may include the first insulating layer INS1 disposed on the p-type semiconductor layer SEM1 around the groove GRV where the light-emitting layer EML is disposed, and the side surface of the light-emitting layer EML may be surrounded by the p-type semiconductor layer SEM1 and the first insulating layer INS1. For example, the upper portion of the light-emitting layer EML may be surrounded by the first insulating layer INS1, and the remaining portion of the light-emitting layer EML may be surrounded by the p-type semiconductor layer SEM1. Accordingly, the contact or bonding between the p-type semiconductor layer SEM1 and the n-type semiconductor layer SEM2 may be stably prevented. Accordingly, poor driving of the light-emitting element LE may be prevented, and the luminous efficiency of the light-emitting element LE may be further improved.

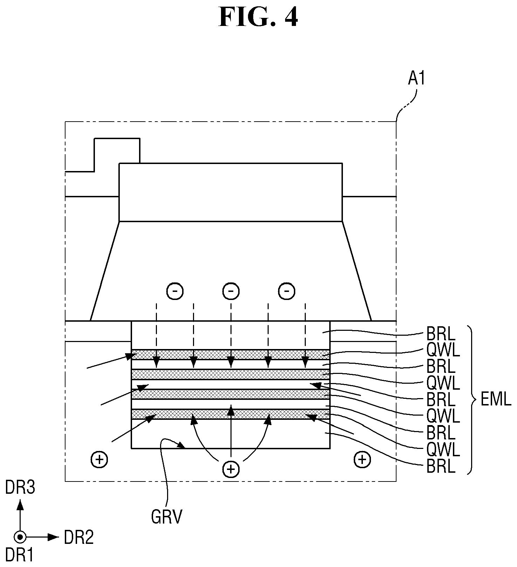

FIG. 4 is an enlarged cross-sectional view of area A1 of FIG. 3. For example, FIG. 4 shows the specific structure of the light-emitting layer EML shown in FIGS. 2 and 3, and inflow paths of holes (+) and electrons (-) flowing into the light-emitting layer EML. In FIG. 4, a solid arrow may roughly indicate the direction of movement of holes (+), and a dotted arrow may roughly indicate the direction of movement of electrons (-).

Referring to FIGS. 1 to 4, the light-emitting layer EML may have a multiple quantum well structure including a barrier layer BRL and a quantum well layer QWL. For example, the light-emitting layer EML may include a plurality of quantum well layers QWL and a plurality of barrier layers BRL that are alternately arranged on the p-type semiconductor layer SEM1 (e.g., on a part of the p-type semiconductor layer SEM1 including the groove GRV) along the third direction DR3.

The quantum well layers QWL may be disposed at a height less than or about equal to the height of the p-type semiconductor layer SEM1. The side surfaces of the quantum well layers QWL may be completely surrounded or covered by the p-type semiconductor layer SEM1. Accordingly, the amount (number) of holes (+) injected into the quantum well layers QWL may be effectively increased. For example, holes (+) may be injected from the p-type semiconductor layer SEM1 into the quantum well layers QWL through the side surfaces of the quantum well layers QWL in addition to the top surfaces and/or the bottom surfaces of the quantum well layers QWL. Accordingly, the luminous efficiency of the light-emitting element LE may be improved more effectively.

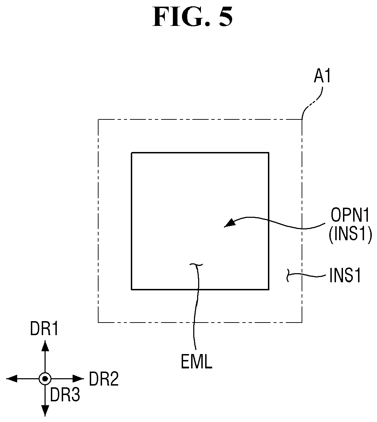

FIG. 5 is a plan view showing the arrangement shape of the light-emitting layer EML and the first insulating layer INS1. For example, FIG. 5 schematically shows the arrangement shape of the light-emitting layer EML and the first insulating layer INS1 at a location corresponding to area A1 of FIG. 3.

Referring to FIGS. 1 to 5, the first insulating layer INS1 may be disposed around the light-emitting layer EML and may include a first opening OPN1 corresponding to the light-emitting layer EML. For example, the first insulating layer INS1 may include the first opening OPN1 overlapping the groove GRV of the p-type semiconductor layer SEM1 where the light-emitting layer EML is disposed, and may be disposed on the p-type semiconductor layer SEM1 around the groove GRV to surround or cover at least a part of the light-emitting layer EML. The light-emitting element LE may include the plurality of light-emitting layers EML disposed in the plurality of grooves GRV, and the first insulating layer INS1 may include a plurality of first openings OPN1 corresponding to the respective grooves GRV.

Although FIG. 5 illustrates an example in which the groove GRV and the light-emitting layer EML have a quadrilateral planar shape, the invention is not limited thereto. For example, the groove GRV and the light-emitting layer EML may have a planar shape corresponding to a non-quadrilateral polygonal shape, a circular shape, or another shape. Further, the first insulating layer INS1 may include the first opening OPN1 having a shape corresponding to the shapes of the groove GRV and the light-emitting layer EML.

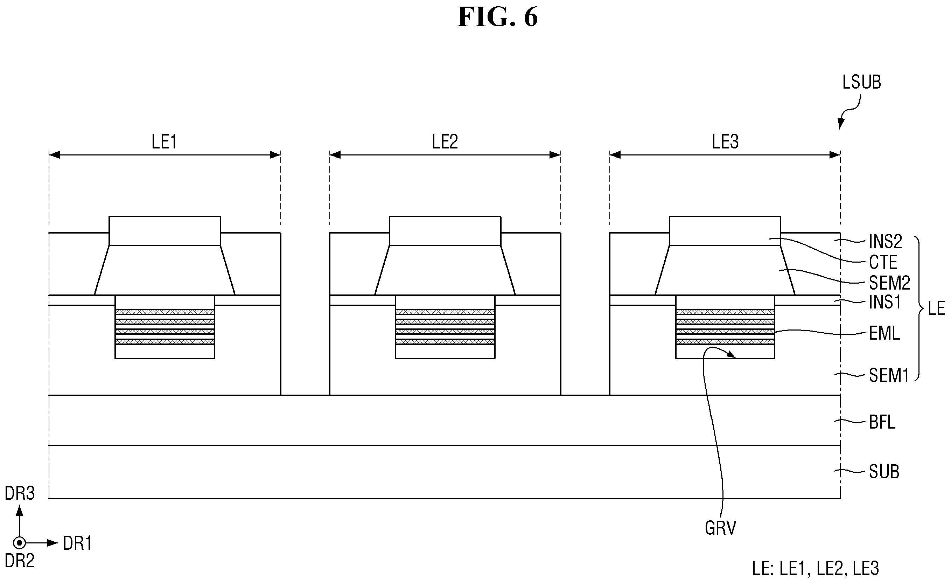

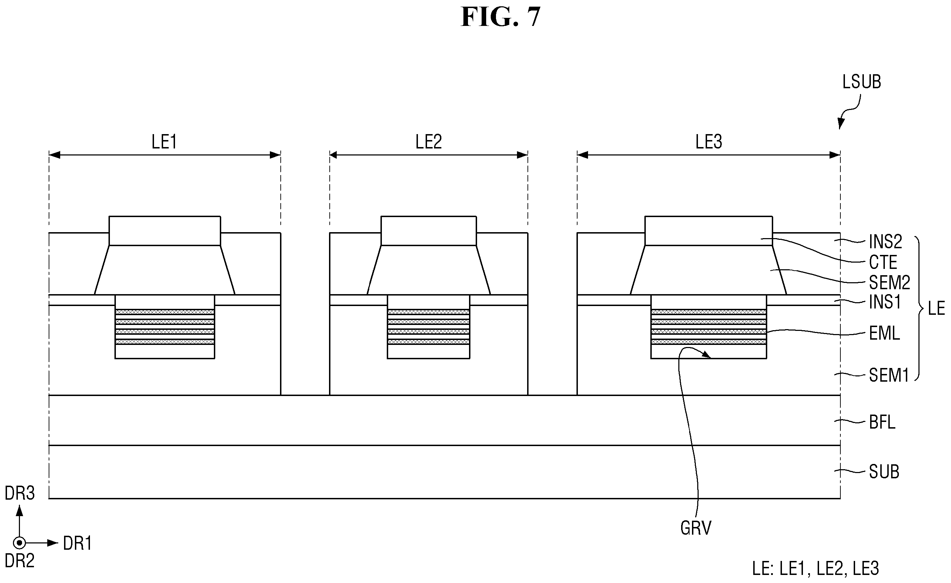

FIG. 6 is a cross-sectional view showing a light-emitting element substrate LSUB including the light-emitting elements LE. FIG. 7 is a cross-sectional view showing the light-emitting element substrate LSUB including the light-emitting elements LE. FIGS. 6 and 7 show different examples in relation to the size of the light-emitting elements LE.

Referring to FIGS. 6 and 7 in addition to FIGS. 1 to 5, the light-emitting element substrate LSUB may include the substrate SUB and the plurality of light-emitting elements LE disposed on the substrate SUB. For example, the light-emitting element substrate LSUB may include a first light-emitting element LE1, a second light-emitting element LE2, and a third light-emitting element LE3 that are arranged to be spaced apart from each other on the substrate SUB along the first direction DR1. Each of the first light-emitting element LE1, the second light-emitting element LE2, and the third light-emitting element LE3 may have a structure that is substantially the same as or similar to that of the light-emitting element LE, according to the examples of FIGS. 1 to 5.

Although FIGS. 6 and 7 illustrate the light-emitting element substrate LSUB in which the plurality of light-emitting elements LE are disposed on the substrate SUB along the first direction DR1, the invention is not limited thereto. For example, the light-emitting element substrate LSUB may include the plurality of light-emitting elements LE in at least one of the first direction DR1 or the second direction DR2. For example, the light-emitting element substrate LSUB may include the plurality of light-emitting elements LE arranged along the second direction DR2.

The first light-emitting element LE1, the second light-emitting element LE2, and the third light-emitting element LE3 may be formed together on the substrate SUB and may be patterned to be separated or spaced apart from each other. For example, after the n-type semiconductor layers SEM2 and the light-emitting layers EML of the first light-emitting element LE1, the second light-emitting element LE2, and the third light-emitting element LE3 are formed, the first light-emitting element LE1, the second light-emitting element LE2, and the third light-emitting element LE3 may be separated into individual patterns by etching the p-type semiconductor layer SEM1 or the like.

The first light-emitting element LE1, the second light-emitting element LE2, and the third light-emitting element LE3 may include the light-emitting layers EML that emit light of the same color, and the light-emitting layers EML of the first light-emitting element LE1, the second light-emitting element LE2, and the third light-emitting element LE3 may be formed substantially at the same time. For example, the light-emitting layers EML of the first light-emitting element LE1, the second light-emitting element LE2, and the third light-emitting element LE3 may be formed substantially at the same time by epitaxial regrowth in a state where the respective grooves GRV are exposed.

The first light-emitting element LE1, the second light-emitting element LE2, and the third light-emitting element LE3 may include the light-emitting layers EML that emit lights of different colors, and the light-emitting layers EML of the first light-emitting element LE1, the second light-emitting element LE2, and the third light-emitting element LE3 may be formed sequentially or in stages. For example, the respective grooves GRV may be sequentially exposed at positions corresponding to the first light-emitting element LE1, the second light-emitting element LE2, and the third light-emitting element LE3, and the light-emitting layers EML of the first light-emitting element LE1, the second light-emitting element LE2, and the third light-emitting element LE3 may be formed sequentially or in stages in and/or above the respective exposed grooves GRV by epitaxial regrowth.

The light-emitting element substrate LSUB may include the light-emitting elements LE of a uniform size (e.g., the same area, height, and/or volume). For example, as shown in FIG. 6, the first light-emitting element LE1, the second light-emitting element LE2, and the third light-emitting element LE3 may be formed to be substantially the same size. Further, the light-emitting layers EML of the first light-emitting element LE1, the second light-emitting element LE2, and the third light-emitting element LE3 may also be formed to be substantially the same size.

The light-emitting element substrate LSUB may include at least two light-emitting elements LE having different sizes. As shown in FIG. 7, the first light-emitting element LE1, the second light-emitting element LE2, and the third light-emitting element LE3 may be formed in different sizes, and the light-emitting layers EML of the first light-emitting element LE1, the second light-emitting element LE2, and the third light-emitting element LE3 may be formed in different sizes. For example, the second light-emitting element LE2 may be formed in a size smaller than those of the first light-emitting element LE1 and the third light-emitting element LE3, and the light-emitting layer EML of the second light-emitting element LE2 may be formed in a size smaller than those of the light-emitting layer EML of the first light-emitting element LE1 and the light-emitting layer EML of the third light-emitting element LE3. The third light-emitting element LE3 may be formed in a size larger than those of the first light-emitting element LE1 and the second light-emitting element LE2, and the light-emitting layer EML of the third light-emitting element LE3 may be formed in a size larger than those of the light-emitting layer EML of the first light-emitting element LE1 and the light-emitting layer EML of the second light-emitting element LE2. The first light-emitting element LE1, the second light-emitting element LE2, and the third light-emitting element LE3 may be formed in substantially the same size, but the light-emitting layers EML of the first light-emitting element LE1, the second light-emitting element LE2, and the third light-emitting element LE3 may be formed in different sizes. The first light-emitting element LE1, the second light-emitting element LE2, and the third light-emitting element LE3 may be formed in different sizes, but the light-emitting layers EML of the first light-emitting element LE1, the second light-emitting element LE2, and the third light-emitting element LE3 may be formed in substantially the same size.

The light-emitting elements LE of different sizes or the light-emitting elements LE including the light-emitting layers EML of different sizes may be light-emitting elements that emit lights of different colors. However, the invention is not limited thereto. For example, the light-emitting elements LE that emit light of the same color may be formed in different sizes, if necessary.

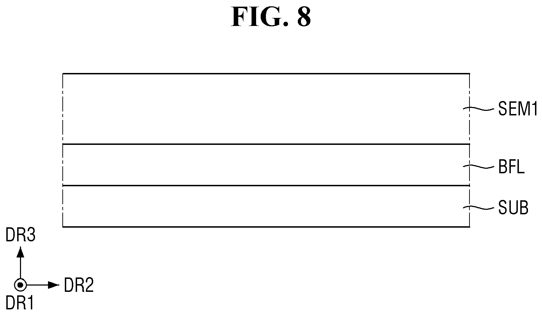

FIGS. 8 to 16 are cross-sectional views showing a method for manufacturing the light-emitting element LE. For example, FIGS. 8 to 16 sequentially illustrate manufacturing steps for manufacturing the light-emitting element LE, according to the example of FIGS. 1 to 3.

Referring to FIG. 8, the substrate SUB for manufacturing the light-emitting element LE by utilizing an epitaxial growth method may be prepared, and the p-type semiconductor layer SEM1 may be formed on the substrate SUB. The buffer layer BFL may be first formed on the substrate SUB and, then, the p-type semiconductor layer SEM1 may be formed on the buffer layer BFL.

The substrate SUB may be a semiconductor substrate suitable for epitaxial growth, where the substrate SUB may be a semiconductor substrate containing the materials exemplified above. For example, the substrate SUB may be a silicon or sapphire substrate, but is not limited thereto.

When the substrate SUB is prepared, the buffer layer BFL may be formed on the substrate SUB. The buffer layer BFL may be formed of an undoped semiconductor material (e.g., undoped GaN) including the materials exemplified above.

Thereafter, The p-type semiconductor layer SEM1 may be formed on the buffer layer BFL. The p-type semiconductor layer SEM1 may be formed of the semiconductor material exemplified above, and may be doped to contain the p-type dopant. For example, the p-type semiconductor layer SEM1 may be formed as a semiconductor layer containing GaN (e.g., p-GaN) doped with the p-type dopant, but is not limited thereto.

The buffer layer BFL and the p-type semiconductor layer SEM1 may be formed on the substrate SUB by epitaxial growth. For example, the buffer layer BFL and the p-type semiconductor layer SEM1 may be sequentially formed on the substrate SUB by epitaxial growth utilizing process technology such as metal-organic chemical vapor deposition (MOCVD), metal-organic vapor phase epitaxy (MOVPE), molecular beam epitaxy (MBE), liquid phase epitaxy (LPE), or vapor phase epitaxy (VPE). The materials and methods for forming the buffer layer BFL and the p-type semiconductor layer SEM1 are not limited to the exemplified materials and methods, and may be variously changed.

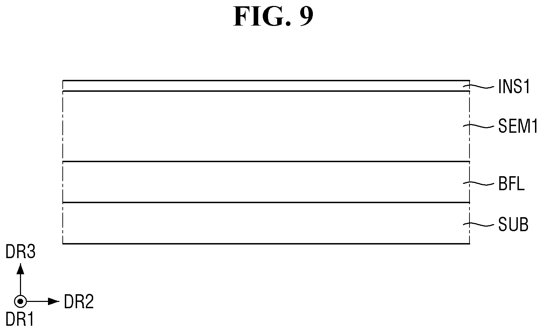

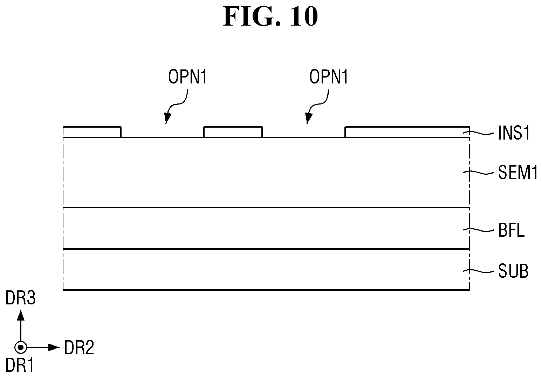

Referring to FIGS. 9 and 10, the first insulating layer INS1 may be formed on the p-type semiconductor layer SEM1. For example, first, as shown in FIG. 9, the first insulating layer INS1 may be entirely formed on the p-type semiconductor layer SEM1. The first insulating layer INS1 may be formed of the insulating material exemplified above. The first insulating layer INS1 may be formed by a deposition method utilizing process technology such as ALD or CVD, but the method for forming the first insulating layer INS1 is not limited thereto.

Then, as shown in FIG. 10, the first opening OPN1 may be formed in the first insulating layer INS1. For example, the first opening OPN1 may be formed in the first insulating layer INS1 by etching the first insulating layer INS1 to expose a part of the p-type semiconductor layer SEM1 corresponding to the area where the light-emitting layer EML is to be formed. In the case of manufacturing the light-emitting element LE including the plurality of light-emitting layers EML, the plurality of first openings OPN1 may be formed in each light-emitting element area where each light-emitting element LE is to be formed. By adjusting or changing the size of the first opening OPN1, it is possible to appropriately adjust or change the size of the light-emitting layer EML to be formed in the first opening OPN1, and/or the size of the light-emitting element LE including the light-emitting layer EML.

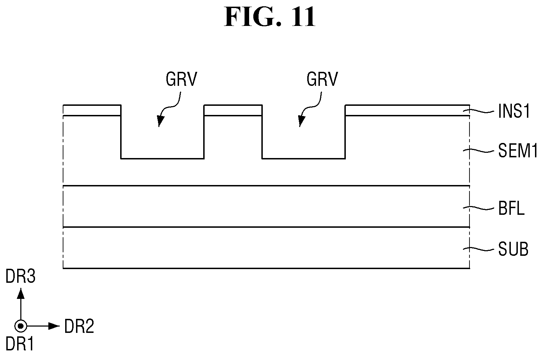

Referring to FIG. 11, the groove GRV may be formed in the p-type semiconductor layer SEM1. The p-type semiconductor layer SEM1 may be etched by utilizing the first insulating layer INS1 as a mask. For example, the groove GRV may be formed in the p-type semiconductor layer SEM1 by etching a part of the p-type semiconductor layer SEM1 that is exposed by the first opening OPN1 of the first insulating layer INS1 to a certain thickness. In each light-emitting element area, the plurality of first openings OPN1 may be formed in the first insulating layer INS1, and the plurality of grooves GRV may be formed in the p-type semiconductor layer SEM1.

Due to the above-described manufacturing process, it is possible to prepare a patterned substrate on which the area where the light-emitting layer EML or the like is to be formed is defined. For example, the patterned substrate may be prepared as a p-type semiconductor substrate including the p-type semiconductor layer SEM1 that is grown on the substrate SUB and etched to include the groove GRV and is covered by the first insulating layer INS1 at the other portions except the groove GRV.

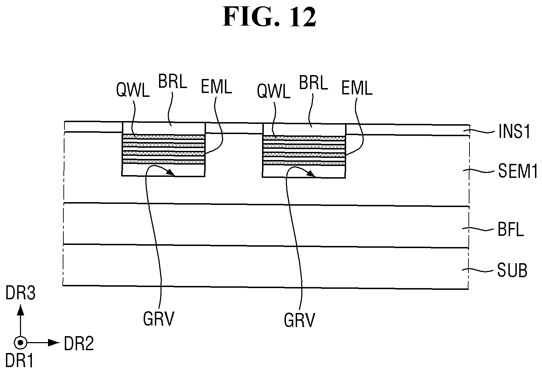

Referring to FIG. 12, the light-emitting layer EML may be formed in the groove GRV (or the groove GRV defined by the first insulating layer INS1 and the p-type semiconductor layer SEM1) of the p-type semiconductor layer SEM1. The light-emitting layer EML may be formed of the semiconductor material exemplified above, and may be formed in a multiple quantum well structure including the barrier layer BRL and the quantum well layer QWL. For example, by alternately forming the barrier layer BRL containing GaN, AlGaN or GaAlN and the quantum well layer QWL containing InGaN on a part of the p-type semiconductor layer SEM1 that is exposed by the first opening OPN1, the light-emitting layer EML of the multiple quantum well structure may be formed.

The light-emitting layer EML may be formed to have a height greater than or equal to that of the height of the p-type semiconductor layer SEM1. For example, the light-emitting layer EML may be formed up to the height of the first insulating layer INS1. Each quantum well layer QWL may be formed at a height less than or equal to the height of the p-type semiconductor layer SEM1, and thus may be surrounded or covered by the p-type semiconductor layer SEM1. The barrier layer BRL located at the uppermost part of the light-emitting layer EML may be formed to have a height greater than or equal to the height of the p-type semiconductor layer SEM1, and thus may be surrounded or covered by the first insulating layer INS1.

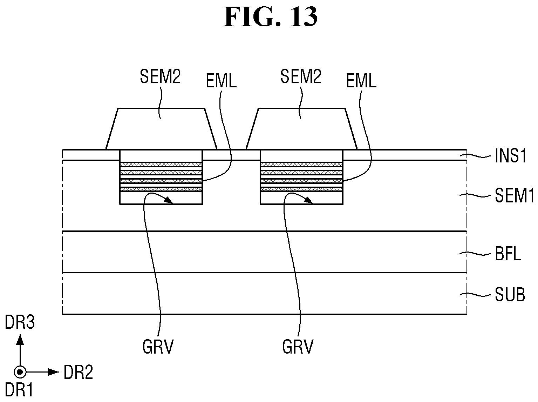

Referring to FIG. 13, the n-type semiconductor layer SEM2 may be formed on the light-emitting layer EML. The n-type semiconductor layer SEM2 may be formed of the semiconductor material exemplified above, and may be doped to contain the n-type dopant. For example, the n-type semiconductor layer SEM2 may be formed as a semiconductor layer including GaN doped with the n-type dopant (e.g., n-GaN), but is not limited thereto.

The n-type semiconductor layer SEM2 may be formed to have an area larger than that of the light-emitting layer EML. For example, a part of the n-type semiconductor layer SEM2 may be formed on a part of the first insulating layer INS1 disposed adjacent to the groove GRV.

The light-emitting layer EML and the n-type semiconductor layer SEM2 may be formed on the p-type semiconductor layer SEM1 by epitaxial regrowth (or epitaxial growth). For example, the light-emitting layer EML and the n-type semiconductor layer SEM2 may be sequentially formed on the p-type semiconductor layer SEM1 by epitaxial regrowth utilizing process technology such as MOCVD, MOVPE, MBE, LPE, or VPE. The materials and methods for forming the light-emitting layer EML and the n-type semiconductor layer SEM2 are not limited to the exemplified materials and methods, and may be variously changed.

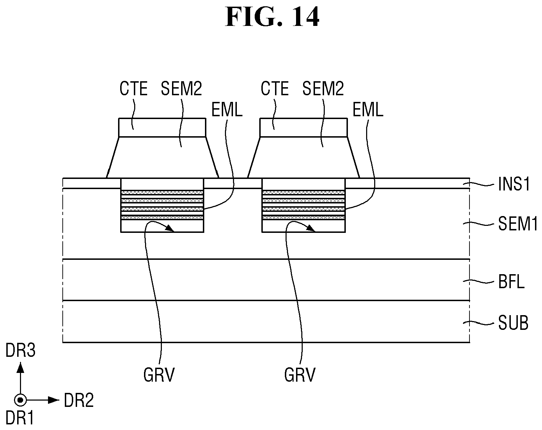

Referring to FIG. 14, the contact electrode CTE may be formed on the n-type semiconductor layer SEM2. In the case of manufacturing the light-emitting element LE that does not include the contact electrode CTE, a process of forming the contact electrode CTE may not be performed.

The contact electrode CTE may be formed of the conductive material exemplified above (e.g., a transparent conductive material). The contact electrode CTE may be formed in a shape corresponding to the n-type semiconductor layer SEM2. For example, the contact electrode CTE may be formed in a shape and/or size corresponding to the shape (e.g., planar shape) and/or size (e.g., area) of the n-type semiconductor layer SEM2.

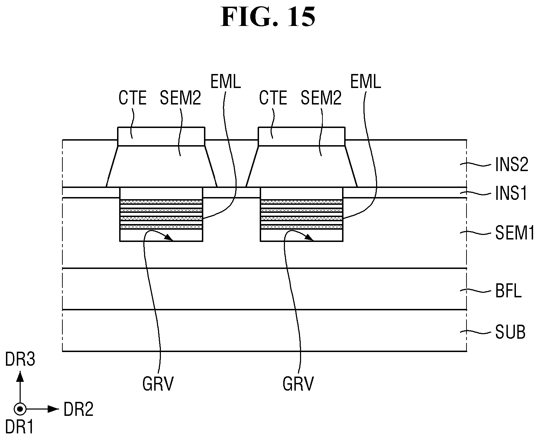

Referring to FIG. 15, the second insulating layer INS2 may be formed on the first insulating layer INS1. The second insulating layer INS2 may be formed of the insulating material exemplified above (e.g., an organic insulating material or the like), and may reduce the stepped portion caused by the n-type semiconductor layer SEM2 and/or the contact electrode CTE. The second insulating layer INS2 may be formed to have a height greater than or equal to the height of the n-type semiconductor layer SEM2, and may surround or cover the side surface of the n-type semiconductor layer SEM2. The second insulating layer INS2 may be formed to have a height less than or equal to the height of the contact electrode CTE. Accordingly, the top surface of the contact electrode CTE may be exposed. The second insulating layer INS2 may be formed to surround or cover a part (e.g., lower portion) of the contact electrode CTE.

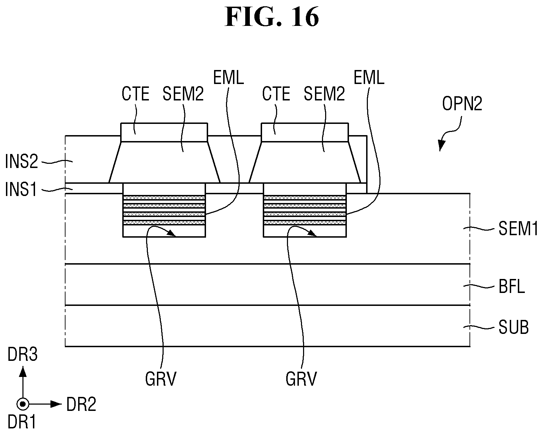

Referring to FIG. 16, a part of the p-type semiconductor layer SEM1 may be exposed by etching the first insulating layer INS1 and the second insulating layer INS2 at a location spaced apart from the groove GRV. For example, by etching the first insulating layer INS1 and the second insulating layer INS2 at a location spaced apart from the groove GRV, a second opening OPN2 may be formed in the first insulating layer INS1 and the second insulating layer INS2. The second opening OPN2 may expose a part of the p-type semiconductor layer SEM1 at a location spaced apart from the groove GRV.

In the case of manufacturing the light-emitting element LE including the first electrode ET1 and the second electrode ET2 shown in FIG. 3, a process of forming the first electrode ET1 and the second electrode ET2 may be additionally performed. For example, the first electrode ET1 may be formed on a part of the p-type semiconductor layer SEM1 that is exposed by the second opening OPN2, and the second electrode ET2 may be formed on the second insulating layer INS2 and the contact electrode CTE. A part of the second electrode ET2 may be directly disposed on the contact electrode CTE. Accordingly, the second electrode ET2 may be connected to the contact electrode CTE.

In the case of manufacturing the plurality of light-emitting elements LE on the substrate SUB, a process of forming the light-emitting elements LE into individual patterns by etching the p-type semiconductor layer SEM1 or the like may be additionally performed. For example, as shown in FIG. 6 or 7, the light-emitting elements LE may be patterned into individual patterns such that the light-emitting elements LE are spaced apart or separated from each other on the substrate SUB.

In the case of manufacturing the light-emitting element LE (or the light-emitting elements LE) separated from the substrate SUB or transferring the light-emitting element LE to the backplane substrate of the display panel, a process of separating the light-emitting element LE from the substrate SUB may be additionally performed. The substrate SUB may be separated from the light-emitting element LE by an electrical and/or chemical etching method, laser lift-off, or another method.

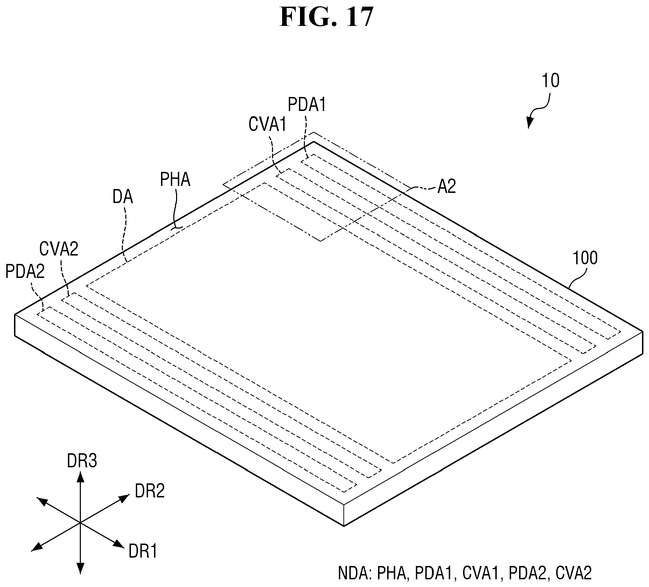

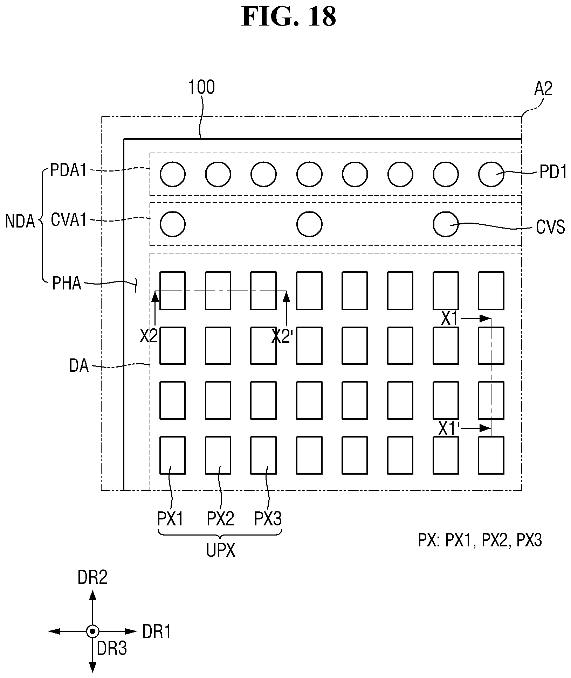

FIG. 17 is a perspective view illustrating a display device 10. FIG. 18 is a plan view showing an example of area A2 of FIG. 17.

Referring to FIGS. 17 and 18, the display device 10 may include a display panel 100 including a display area DA and a non-display area NDA.

The display panel 100 may have a quadrilateral planar shape having long sides in the first direction DR1 and short sides in the second direction DR2. In FIGS. 17 and 18, the first direction DR1 may refer to a horizontal direction (or vertical direction) of the display panel 100, and the second direction DR2 may refer to a vertical direction (or horizontal direction) of the display panel 100. The third direction DR3 may refer to a thickness direction or a height direction of the display panel 100. However, the planar shape of the display panel 100 is not limited thereto, and the display panel 100 may have a different shape. For example, the display panel 100 may have a polygonal shape other than a quadrilateral shape, a circular shape, an elliptical shape, or an irregular shape in plan view.

The display area DA may be where images are displayed, while the non-display area NDA may be where no images are displayed. The planar shape of the display area DA may follow the planar shape of the display panel 100. FIG. 1 illustrates that the display area DA is a quadrilateral shape in plan view. The display area DA may be disposed in a central area of the display panel 100. The non-display area NDA may be disposed around the display area DA. For example, the non-display area NDA may surround the display area DA.

The display panel 100 may include a plurality of pixels PX arranged in the display area DA. For example, the display panel 100 may include first pixels PX1 (e.g., first color sub-pixels) that emit light of a first color, second pixels PX2 (e.g., second color sub-pixels) that emit light of a second color, and third pixels PX3 (e.g., third color sub-pixels) that emit light of a third color. The first color may be blue, the second color may be green, and the third color may be red, but they are not limited thereto. At least one first pixel PX1, at least one second pixel PX2, and at least one third pixel PX3 adjacent to each other may constitute each unit pixel UPX capable of emitting light of various colors. As an example, the first pixel PX1, the second pixel PX2, and the third pixel PX3 sequentially disposed along the first direction DR1 in the K^{th} (K is a natural number) row of the display area DA may constitute one unit pixel UPX. The number, type, and/or arrangement structure of the pixels PX constituting the unit pixel UPX may vary.

Each pixel PX may include at least one light-emitting element LE. Each pixel PX may include the light-emitting element LE according to at least one of the previously described examples. For example, each pixel PX may include the light-emitting element LE including the light-emitting layer EML disposed in the groove GRV of the p-type semiconductor layer SEM1 and surrounded by the p-type semiconductor layer SEM1 and the first insulating layer INS1 as shown in FIGS. 1 to 5.

The pixels PX may include the light-emitting elements LE that emit light of the same color, or may include the light-emitting elements LE that emit lights of different colors. For example, the first pixels PX1, the second pixels PX2, and the third pixels PX3 may include the light-emitting elements LE that emit light of the same color (e.g., blue light or white light), and color filters and/or light conversion patterns (e.g., wavelength conversion patterns including quantum dots) for converting or controlling the color of light emitted from the light-emitting elements LE provided in the respective pixels PX may be disposed in the emission areas of the first pixels PX1, the second pixels PX2 and/or the third pixels PX3. The first pixels PX1, the second pixels PX2, and the third pixels PX3 may include the light-emitting elements LE that emit light of the first color, light of the second color, and light of the third color, respectively.

The pixels PX may include light-emitting elements LE of substantially the same size, or may include light-emitting elements LE of different sizes. For example, the first pixels PX1, the second pixels PX2, and the third pixels PX3 may include the light-emitting elements LE having substantially the same size, or may include the light-emitting elements LE having different sizes.

The pixels PX may be arranged in the display area DA in a matrix form, a stripe form, or any other form. The sizes of the pixels PX (or the emission areas of the pixels PX) may be substantially the same or different from each other. For example, the first pixels PX1, the second pixels PX2, and the third pixels PX3 may have substantially the same size (e.g., the same area) or may have different sizes. The arrangement type, location, or size of the pixels PX may be variously changed.

The pixels PX may have a quadrilateral planar shape such as a rectangular shape or a rhombic shape, but the invention not limited thereto. For example, the pixels PX may have another polygonal shape other than a quadrilateral shape, a circular shape, an elliptical shape, or another shape in plan view.

The non-display area NDA may include a first common voltage supply area CVA1, a second common voltage supply area CVA2, a first pad area PDA1, a second pad area PDA2, and a peripheral area PHA.

The first common voltage supply area CVA1 may be disposed between the first pad area PDA1 and the display area DA. The second common voltage supply area CVA2 may be disposed between the second pad area PDA2 and the display area DA. Each of the first common voltage supply area CVA1 and the second common voltage supply area CVA2 may include a common electrode connection portion CVS electrically connected to the second pixel electrode of each of the pixels PX. The second pixel voltage (e.g., a low-potential pixel voltage or a common voltage) may be supplied to the pixels PX through the common electrode connection portions CVS.

The common electrode connection portions CVS may be disposed in a common voltage supply area (e.g., the first common voltage supply area CVA1 and/or the second common voltage supply area CVA2) of the non-display area NDA. The common electrode connection portions CVS may include a conductive material (e.g., a metal material such as aluminum (Al)). FIGS. 17 and 18 illustrate the display device 10 in which the common electrode connection portions CVS are positioned in the non-display area NDA, but the invention is not limited thereto. For example, the common electrode connection portions CVS may be located in the display area DA.

The common electrode connection portions CVS of the first common voltage supply area CVA1 may be electrically connected to any one of the first pads PD1 of the first pad area PDA1. For example, the common electrode connection portions CVS of the first common voltage supply area CVA1 may receive the second pixel voltage from any one of the first pads PD1 of the first pad area PDA1.

The first pads PD1 may be disposed in the first pad area PDA1. The first pads PD1 may be connected to a circuit board (not shown) through a conductive connection member. For example, the first pads PD1 may be electrically connected to a circuit pad provided on a circuit board through a wire.

The common electrode connection portions CVS of the second common voltage supply area CVA2 may be electrically connected to any one of second pads of the second pad area PDA2. For example, the common electrode connection portions CVS of the second common voltage supply area CVA2 may receive the second pixel voltage from any one of the second pads of the second pad area PDA2. The display panel 100 may not include the second common voltage supply area CVA2.

The first pad area PDA1 may be disposed on one side (e.g., an upper side) of the display panel 100. The first pad area PDA1 may include the first pads PD1 to be connected to an external circuit board.

The second pad area PDA2 may be disposed on one side (e.g., a lower side) of the display panel 100 and may include the second pads connected to an external circuit board. The display panel 100 may not include the second pad area PDA2.

The second pads may be disposed in the second pad area PDA2 of the non-display area NDA and may be connected to a circuit board (not shown) through a conductive connection member. For example, the second pads may be electrically connected to the circuit pads provided on the circuit board through wires.

The peripheral area PHA may be the remaining area of the non-display area NDA except the first common voltage supply area CVA1, the second common voltage supply area CVA2, the first pad area PDA1, and the second pad area PDA2. The peripheral area PHA may surround not only the display area DA, but also the first common voltage supply area CVA1, the second common voltage supply area CVA2, the first pad area PDA1, and the second pad area PDA2.

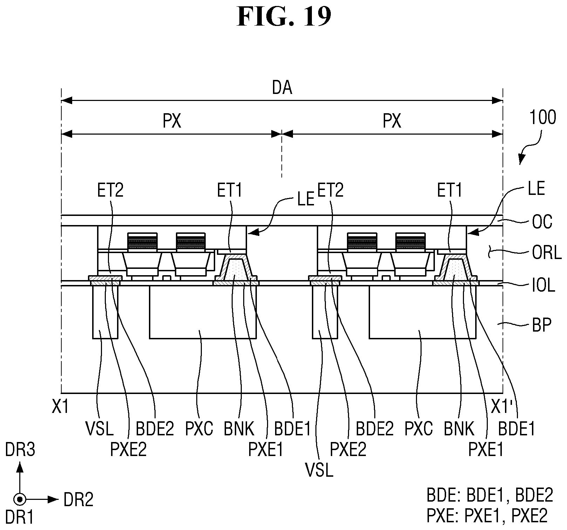

FIG. 19 is a cross-sectional view illustrating the display panel 100. For example, FIG. 19 illustrates an example of a cross section of the display panel 100 corresponding to line X1-X1' of FIG. 18, and illustrates a schematic cross section of two pixels PX disposed adjacent to each other in the second direction DR2.

FIG. 19 illustrates an example in which the display device 10 is a light-emitting diode on silicon (LEDoS) in which light-emitting diodes as the light-emitting elements LE are disposed on a semiconductor circuit board (e.g., the backplane board BP of the display panel 100 on which a pixel circuit PXC or the like is formed based on a silicon wafer) formed by a semiconductor process using a silicon wafer. However, a device including light-emitting elements LE according to the invention is not limited thereto. For example, the light-emitting elements LE may be applied to display devices of different types and/or structures, or may be applied to devices of different types and/or structures, such as lighting devices. For example, the light-emitting elements LE described above may also be applied to manufacture of devices of different types and/or structures.

Referring to FIGS. 17 to 19, the display panel 100 may include the backplane substrate BP and the light-emitting elements LE disposed on the backplane substrate BP. Further, the display panel 100 may further include pixel structures and electrodes disposed around the light-emitting elements LE on the backplane substrate BP.

The display panel 100 may further include an additional component. As an example, the display panel 100 may further include at least one of a light conversion layer for converting the color and/or wavelength of light emitted from at least some of the light-emitting elements LE, a color filter layer for performing control such that light of a specific color is emitted from each of the emission areas EA, or a light output structure (e.g., a lens, or the like) for improving the light emission efficiency of the pixels PX.

The backplane substrate BP may include the display area DA where the pixels PX are arranged. The backplane substrate BP may be a semiconductor circuit board formed by a semiconductor process using a silicon wafer. For example, a silicon wafer may be used as a base member for forming the display panel 100. The backplane substrate BP may further include the non-display area NDA shown in FIGS. 17 and 18. The backplane substrate BP may further include the common electrode connection portions CVS, the first pads PD1, and/or second pads that are located in the non-display area NDA.

The backplane substrate BP may include the pixel circuits PXC and wires provided in the display area DA. The wires may include a power line VSL connected to the second pixel electrodes PXE2 of the pixels PX, and the second pixel electrodes PXE2 may be connected to the common electrode connection portions CVS through the power line VSL. The second pixel electrodes PXE2 may be formed to be connected to each other in a mesh shape in the display area DA and may extend to the non-display area NDA to be directly connected to the common electrode connection portions CVS. In addition, the connection structure of the second pixel electrodes PXE2 and the common electrode connection portions CVS may be variously changed. FIG. 19 only illustrates schematic positions of the pixel circuits PXC and the power line VSL.

Each pixel PX may include the first pixel electrode PXE1 and the second pixel electrode PXE2, and the light-emitting element LE connected between the first pixel electrode PXE1 and the second pixel electrode PXE2. Each pixel PX may further include the pixel circuit PXC connected to the first pixel electrode PXE1.

The pixel circuits PXC may be provided in the display area DA to correspond to the areas where the respective pixels PX are formed. Each of the pixel circuits PXC may include a complementary metal oxide semiconductor (CMOS) circuit formed on the backplane substrate BP using a semiconductor process.

Each of the pixel circuits PXC may include at least one transistor formed by the semiconductor process. Further, each of the pixel circuits PXC may further include at least one capacitor formed by the semiconductor process.

The pixel circuit PXC of each of the pixels PX may be electrically connected to the first pixel electrode PXE1 of the corresponding pixel PX. Each of the pixel circuits PXC may apply a first pixel voltage (e.g., a high-potential pixel voltage) to the first pixel electrode PXE1 connected thereto.

The light-emitting elements LE and the pixel electrodes PXE of the pixels PX may be disposed on the backplane substrate BP. At least one of bonding electrodes BDE, a bank BNK, or insulating layers may be further disposed on the backplane substrate BP. The insulating layers on the backplane substrate BP may include an inorganic film IOL, an organic film ORL, and an overcoat layer OC.

The pixel electrodes PXE may include the first pixel electrode PXE1 and the second pixel electrode PXE2 of each pixel PX. The pixel electrodes PXE may be single-layer or multilayer electrodes including at least one conductive material.

Each first pixel electrode PXE1 may be electrically connected to the pixel circuit PXC of the corresponding pixel PX. Further, each first pixel electrode PXE1 may be electrically connected to the first electrode ET1 of the light-emitting element LE provided in the corresponding pixel PX. For example, each first pixel electrode PXE1 may be connected between the pixel circuit PXC of the corresponding pixel PX and the first electrode ET1 of the light-emitting element LE.

Each second pixel electrode PXE2 may be connected to at least one common electrode connection portion CVS or the power line VSL connected thereto. Further, each second pixel electrode PXE2 may be electrically connected to the second electrode ET2 of the light-emitting element LE provided in the corresponding pixel PX. For example, each second pixel electrode PXE2 may be connected between the power line VSL (or the common electrode connection portion CVS) and the second electrode ET2 of the light-emitting element LE.

At least one insulating layer may be disposed around the pixel electrodes PXE. For example, the inorganic film IOL may be disposed around the pixel electrodes PXE. The inorganic film IOL may expose at least a part (e.g., the top surfaces) of the pixel electrodes PXE. The inorganic film IOL may include at least one inorganic insulating material (e.g., silicon oxide (SiOₓ), silicon nitride (SiNₓ), aluminum oxide (AlₓO_{y}), titanium oxide (TiₓO_{y}), hafnium oxide (HfOₓ), or another inorganic insulating material).

The bonding electrodes BDE may be disposed on the pixel electrodes PXE. For example, a first bonding electrode BDE1 may be disposed on each first pixel electrode PXE1, and a second bonding electrode BDE2 may be disposed on each second pixel electrode PXE2.

Each first bonding electrode BDE1 may be disposed between the first pixel electrode PXE1 of each pixel PX and the first electrode ET1 of the light-emitting element LE. Each first bonding electrode BDE1 may connect the first pixel electrode PXE1 of each pixel PX to the first electrode ET1 of the light-emitting element LE.

The bank BNK may be disposed under each first bonding electrode BDE1. For example, the bank BNK may be disposed between each first pixel electrode PXE1 and the first bonding electrode BDE1, and at least a part of the first bonding electrode BDE1 may protrude in an upward direction. Accordingly, each first bonding electrode BDE1 may be in contact with or connected to the first electrode ET1 of the light-emitting element LE. The bank BNK may include an organic insulating material, but it not limited thereto.

Each second bonding electrode BDE2 may be disposed between the second pixel electrode PXE2 of each pixel PX and the second electrode ET2 of the light-emitting element LE. Each second bonding electrode BDE2 may connect the second pixel electrode PXE2 of each pixel PX to the second electrode ET2 of the light-emitting element LE.

The bonding electrodes BDE may be single-layer or multilayer electrodes including at least one conductive material. The bonding electrodes BDE may contain a conductive bonding material suitable for bonding or adhering the light-emitting elements LE onto the pixel electrodes PXE. For example, the bonding electrodes BDE may be single-layer or multilayer electrodes containing gold (Au), copper (Cu), aluminum (Al), tin (Sn), or another metal material. When the backplane substrate BP does not include the bonding electrodes BDE and the light-emitting elements LE are directly bonded or adhered onto the pixel electrodes PXE, the pixel electrodes PXE may contain a conductive material (e.g., a metal material suitable for use as a bonding metal) that may be appropriately connected to the light-emitting elements LE by a bonding process or an adhesion process.

The pixels PX may include the light-emitting elements LE described above. For example, each pixel PX may include at least one light-emitting element LE connected between the first pixel electrode PXE2 and the second pixel electrode PXE2, and the light-emitting element LE may be the light-emitting element LE according to at least one of the examples of FIGS. 1 to 7. For example, as shown in FIGS. 1 to 3, the light-emitting element LE provided in each pixel PX may include the p-type semiconductor layer SEM1 including the groove GRV, the first insulating layer INS1 disposed on the p-type semiconductor layer SEM1 around the groove GRV, the light-emitting layer EML disposed in the groove GRV and including a side surface surrounded or covered by the p-type semiconductor layer SEM1 and the first insulating layer INS1, and the n-type semiconductor layer SEM2 disposed on the light-emitting layer EML. Each light-emitting element LE may further include at least one of the contact electrode CTE, the second insulating layer INS2, the first electrode ET1, or the second electrode ET2. Each light-emitting element LE may be disposed such that the surface on which the contact electrode CTE, the first electrode ET1, and the second electrode ET2 are formed faces the backplane substrate BP. Accordingly, the first electrode ET1 and the second electrode ET2 may be appropriately bonded onto the bonding electrodes BDE (or the pixel electrodes PXE).

At least one insulating layer may be disposed around the light-emitting elements LE. For example, the organic film ORL may be disposed around the light-emitting elements LE. The organic film ORL may be a filler filled between the light-emitting elements LE. The organic film ORL may be formed to have substantially the same height or a similar height to the light-emitting elements LE, and thus may reduce the stepped portion caused by the light-emitting elements LE. The organic film ORL may include an organic insulating material. For example, the organic film ORL may be a single-layer or multilayer organic insulating layer containing acrylic resin, epoxy resin, phenolic resin, polyamide resin, and polyimide resin, or another organic insulating material.

The overcoat layer OC may be disposed on the light-emitting elements LE and the organic film ORL. The overcoat layer OC may be entirely disposed or formed in the display area DA. The overcoat layer OC may be a single-layer or multilayer insulating layer containing at least one insulating material.

The display panel 100 may further include an additional component. For example, the display panel 100 may further include at least one of a reflective layer and a light blocking layer disposed around the light-emitting elements LE, or a capping layer disposed between the light-emitting elements LE and the overcoat layer OC.

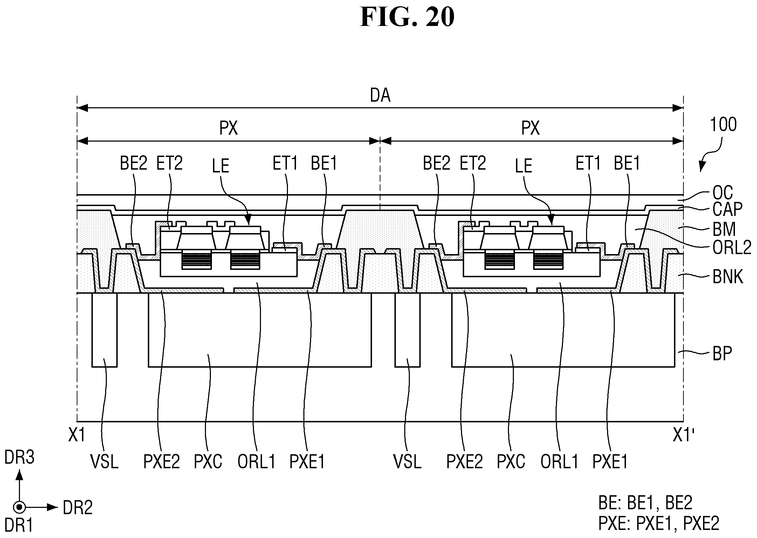

FIG. 20 is a cross-sectional view illustrating the display panel 100. For example, FIG. 20 illustrates one example of a cross section of the display panel 100 corresponding to line X1-X1' of FIG. 18 and illustrates a schematic cross section of two pixels PX disposed adjacent to each other in the second direction DR2.

FIG. 20 shows an example where a cross section of pixels PX in which the arrangement direction of the light-emitting elements LE is different from that of FIG. 19. In describing the example of FIG. 20, redundant descriptions of components identical to or similar to those of FIG. 19 will be omitted.

Referring to FIGS. 17 to 20, each light-emitting element LE may be disposed such that a surface on which the contact electrode CTE, the first electrode ET1, and the second electrode ET2 are formed faces the top surface of the display panel 100. Further, each light-emitting element LE may be connected to the pixel electrodes PXE through bridge electrodes BE. For example, the display panel 100 may further include the bridge electrodes BE connected between the light-emitting elements LE and the pixel electrodes PXE. The first electrode ET1 of the light-emitting element LE may be connected to the first pixel electrode PXE1 through a first bridge electrode BE1, and the second electrode ET2 of the light-emitting element LE may be connected to the second pixel electrode PXE2 through a second bridge electrode BE2. The display panel 100 may not include the bonding electrodes BDE according to the example of FIG. 19.

The display panel 100 may further include a first organic film ORL1 disposed on the backplane substrate BP, and the light-emitting elements LE may be disposed on the first organic film ORL1. The first organic film ORL1 may be disposed on the pixel electrodes PXE to overlap at least a part of the pixel electrodes PXE in each pixel PX, but the invention is not limited thereto. In a process of transferring the light-emitting elements LE to the display panel 100, the light-emitting elements LE may be temporarily fixed or adhered by the first organic film ORL1.

The bank BNK may be disposed on the backplane substrate BP to define respective pixel areas (or the emission areas of the pixels PX) where the respective light-emitting elements LE are to be disposed. The bank BNK may be disposed between the backplane substrate BP and the pixel electrodes PXE to overlap a part of the pixel electrodes PXE. The pixel electrodes PXE may be connected to the respective pixel circuits PXC or the power line VSL through respective contact holes (or via holes) penetrating the bank BNK.

The display panel 100 may further include a light blocking layer BM disposed on the bank BNK. The light blocking layer BM may be disposed around the emission areas of the pixels PX where the light-emitting elements LE are disposed to surround the emission areas.

The display panel 100 may further include a second organic film ORL2 disposed around the light-emitting elements LE. The second organic film ORL2 may be formed to have a height that is substantially the same as or similar to that of the light-emitting elements LE or the light blocking layer BM, so that the stepped portion caused by the light-emitting elements LE and the light blocking layer BM may be reduced.

The display panel 100 may further include a capping layer CAP entirely disposed on the second organic film ORL2 and the light blocking layer BM, and the overcoat layer OC may be disposed on the capping layer CAP. The capping layer CAP may include at least one inorganic insulating material suitable for blocking moisture permeation.

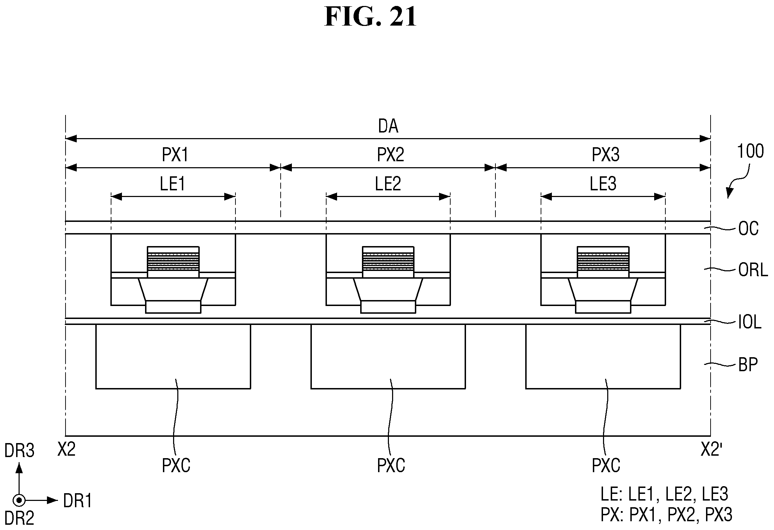

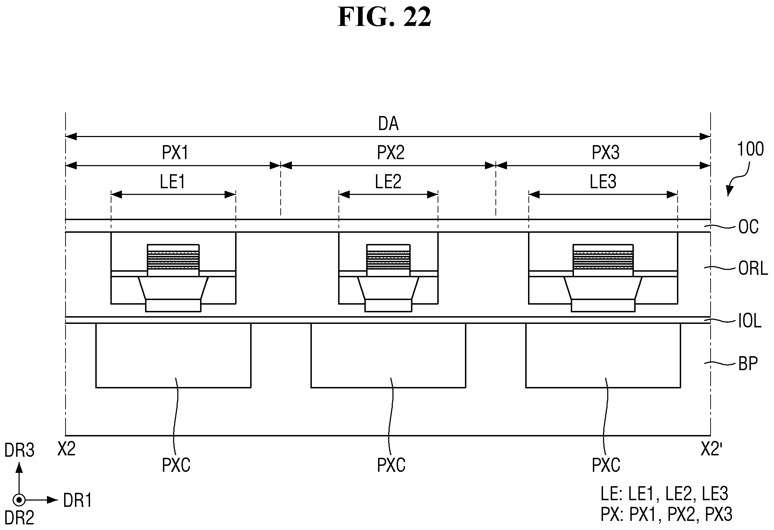

FIG. 21 is a cross-sectional view illustrating the display panel 100. FIG. 22 is a cross-sectional view illustrating the display panel 100. For example, FIGS. 21 and 22 illustrate the cross section of the display panel 100 corresponding to line X2-X2' of FIG. 18, and illustrate different examples in relation to the size of the light-emitting elements LE provided in the pixels PX. Although FIGS. 21 and 22 illustrate the display panel 100 whose surface on which the contact electrodes CTE of the light-emitting elements LE are formed faces the backplane substrate BP as in the example of FIG. 19, it is not limited thereto.

Referring to FIGS. 17 to 21, the pixels PX may include the light-emitting elements LE of substantially the same size. For example, the first light-emitting element LE1, the second light-emitting element LE2, and the third light-emitting element LE3 respectively provided in the first pixel PX1, the second pixel PX2, and the third pixel PX3 may be manufactured in substantially the same size. The first light-emitting element LE1, the second light-emitting element LE2, and the third light-emitting element LE3 may be light-emitting elements that emit light of the same color. The first light-emitting element LE1, the second light-emitting element LE2, and the third light-emitting element LE3 may be light-emitting elements that emit lights of different colors. For example, the first light-emitting element LE1, the second light-emitting element LE2, and the third light-emitting element LE3 may emit light of a first color, light of a second color, and light of a third color, respectively. The pixels PX may include the respective emission areas where the respective light-emitting elements LE are disposed. The emission areas of the pixels PX may have substantially the same size or may have different sizes.

Referring to FIGS. 17 to 22, the pixels PX may include the light-emitting elements LE of different sizes. For example, the first light-emitting element LE1, the second light-emitting element LE2, and the third light-emitting element LE3 that are respectively provided in the first pixel PX1, the second pixel PX2, and the third pixel PX3 may be manufactured in different sizes. For example, the first light-emitting element LE1 may have a larger size (e.g., a larger area) than the second light-emitting element LE2, and may have a smaller size (e.g., a smaller area) than the third light-emitting element LE3. The heights of the first light-emitting element LE1, the second light-emitting element LE2, and the third light-emitting element LE3 may be substantially the same or different from each other.

The first light-emitting element LE1, the second light-emitting element LE2, and the third light-emitting element LE3 may be light-emitting elements that emit light of the same color. The first light-emitting element LE1, the second light-emitting element LE2, and the third light-emitting element LE3 may be light-emitting elements that emit lights of different colors. For example, the first light-emitting element LE1, the second light-emitting element LE2, and the third light-emitting element LE3 may emit light of the first color, light of the second color, and light of the third color, respectively. The size of the light-emitting elements LE or the size of the emission areas where the light-emitting elements LE are arranged may be differentiated depending on the luminous efficiency of each light-emitting element LE or the pixel PX including the same, the area of the emission areas of the pixels PX, or the white balance of light emitted from the pixels PX.

The display device 10 according to the examples of FIGS. 17 to 22 may include the light-emitting element LE (or the pixel PX including the light-emitting element LE manufactured according to FIGS. 8 to 16) according to at least one of the examples of FIGS. 1 to 7. Accordingly, the luminous efficiency of the pixel PX and the display device 10 including the same may be improved.

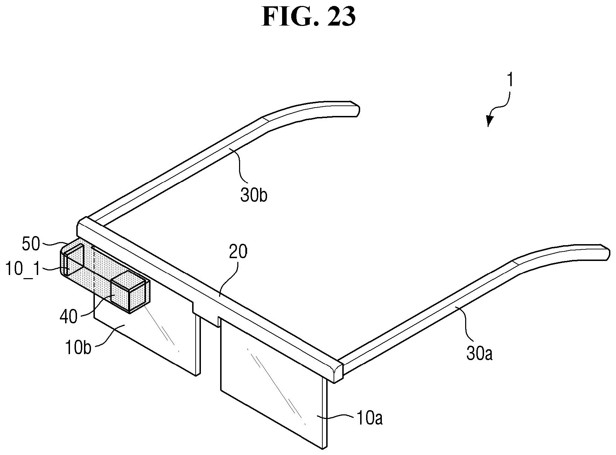

FIG. 23 is a diagram illustrating a virtual reality device 1 including a display device 10_1.

Referring to FIG. 23, the virtual reality device 1 may be a glasses-type device. The virtual reality device 1 may include a display device 10_1, a left eye lens 10a, a right eye lens 10b, a support frame 20, temples 30a and 30b, a reflection member 40, and a display device housing 50.

Although FIG. 23 illustrates an example of the virtual reality device 1 which includes the temples 30a and 30b, the virtual reality device 1 may be applied to a head mounted display including a head mounted band that may be worn on a head, instead of the temples 30a and 30b. For example, the virtual reality device 1 is not limited to the form shown in FIG. 23 and may be applied in various forms to various other electronic devices.

The display device housing 50 may include the display device 10_1 and the reflection member 40. The image displayed on the display device 10_1 may be reflected by the reflection member 40 and provided to a user's right eye through the right eye lens 10b. Accordingly, the user can view the virtual reality image displayed on the display device 10_1 through the right eye.

Although FIG. 23 illustrates an example where the display device housing 50 is disposed at the right end of the support frame 20, the invention is not limited thereto. For example, the display device housing 50 may be disposed at the left end of the support frame 20, and in this case, the image displayed on the display device 10_1 may be reflected by the reflection member 40 and provided to a user's left eye through the left eye lens 10a. Accordingly, the user can view the virtual reality image displayed on the display device 10_1 through the left eye. The display device housing 50 may be disposed at both the left end and the right end of the support frame 20. In that case, the user can view the virtual reality image displayed on the display device 10_1 through both the left eye and the right eye.

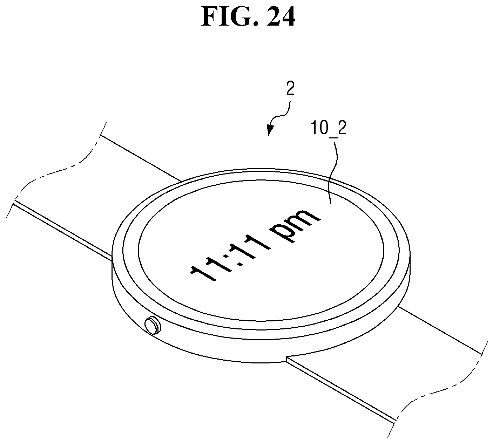

FIG. 24 is a diagram illustrating a smart device including a display device 10_2.

Referring to FIG. 24, the display device 10_2 may be applied to a smart watch 2 that is one of the smart devices. The planar shape of a clock display unit of the smart watch 2 may follow the planar shape of the display device 10_2. For example, when the display device 10_2, has a planar shape such as a circular shape or an elliptical shape, the clock display unit of the smart watch 2 may have a planar shape such as a circular shape or an elliptical shape. When the display device 10_2 has a quadrilateral planar shape, the clock display unit of the smart watch 2 may have a quadrilateral planar shape. However, the invention is not limited thereto, and the clock display unit of the smart watch 2 may not follow the planar shape of the display device 10_2.

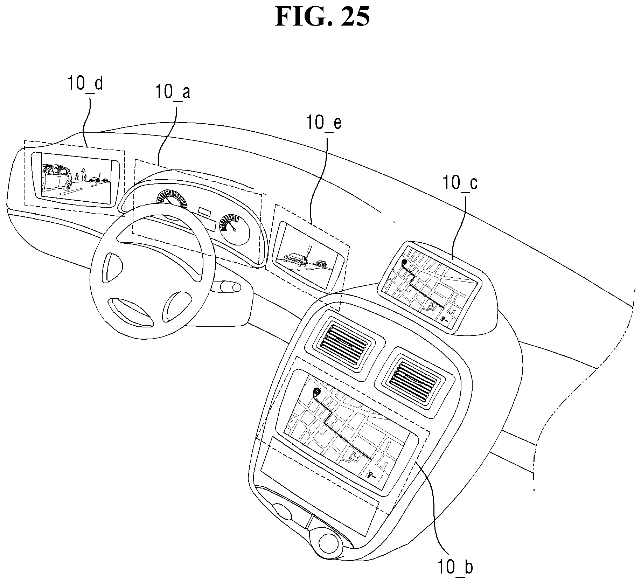

FIG. 25 illustrates an automobile dashboard and center fascia including display devices 10_a, 10_b, 10_c, 10_d, and 10_e. FIG. 25 illustrates a vehicle to which the display devices 10_a, 10_b, 10_c, 10_d, and 10_e, are applied.

Referring to FIG. 25, the display devices 10_a, 10_b, and 10_c may be applied to the dashboard of the automobile, the center fascia of the automobile, or the center information display (CID) of the dashboard of the automobile. The display devices 10_d, and 10_e may be applied to a room mirror display instead of side mirrors of the automobile.

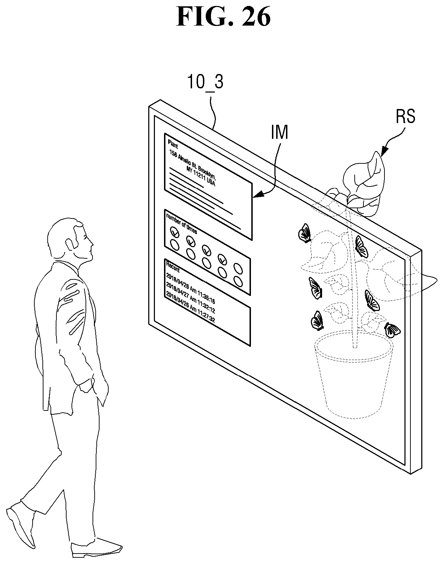

FIG. 26 is a diagram illustrating a transparent display device including a display device 10_3.

Referring to FIG. 26, the display device 10_3 may be applied to the transparent display device. The transparent display device may display an image IM, and also may transmit light. Accordingly, a user located in front of the transparent display device can view an object RS or a background located behind the transparent display device as well as the image IM displayed on the display device 10_3. When the display device 10_3 is applied to a transparent display device, the display panel 100 may include a light transmission portion capable of transmitting light or may be formed on a substrate member made of a material capable of transmitting light.

In concluding the detailed description, those skilled in the art will appreciate that many variations and modifications can be made to the embodiments without substantially departing from the principles of the invention. Therefore, the disclosed embodiments of the invention are used in a generic and descriptive sense only and not for purposes of limitation. Thus, it will be understood by one of ordinary skill in the art to which the invention belongs that the invention may be implemented in other specific embodiments than those described herein without changing the essential features of the invention. Therefore, it is to be understood that the exemplary embodiments described above are illustrative rather than being restrictive in all aspects. The disclosed embodiments of the invention are used in a generic and descriptive sense only and not for purposes of limitation. Each component specifically shown in the embodiments of the invention can be implemented by modification, and such modifications and differences related to invention should be construed as being included in the scope of the invention. Moreover, the embodiments or parts of the embodiments may be combined in whole or in part without departing from the scope of the invention as defined by the claims.

## Claims

1. A light-emitting element (LE) comprising:
a p-type semiconductor layer (SEM1) comprising a groove (GRV);
a first insulating layer (INS1) disposed on the p-type semiconductor layer and disposed around the groove;
a light-emitting layer (EML) disposed in the groove, and having a side surface surrounded by the p-type semiconductor layer and the first insulating layer; and
an n-type semiconductor layer (SEM2) disposed on the light-emitting layer.

2. The light-emitting element of claim 1, wherein the light-emitting layer comprises an upper portion protruding above the p-type semiconductor layer (SEM1) and surrounded by the first insulating layer (INS1), and
a remaining portion of the light-emitting layer, except for the upper portion, is completely surrounded by the p-type semiconductor layer (SEM1).

3. The light-emitting element of claim 1 or 2, wherein the light-emitting layer comprises quantum well layers and barrier layers alternately arranged on the p-type semiconductor layer, wherein
the quantum well layers are disposed at a height that is less than or equal to the height of the p-type semiconductor layer.

4. The light-emitting element of claim 1 or 2, wherein the light-emitting layer comprises quantum well layers and barrier layers alternately arranged on the p-type semiconductor layer, wherein
side surfaces of the quantum well layers are completely surrounded by the p-type semiconductor layer.

5. The light-emitting element of any one of the preceding claims, wherein the n-type semiconductor layer comprises an edge portion overlapping the p-type semiconductor layer, wherein
the first insulating layer is interposed between the p-type semiconductor layer and the n-type semiconductor layer at a portion where the p-type semiconductor layer and the n-type semiconductor layer overlap.

6. The light-emitting element of any one of the preceding claims, wherein the first insulating layer comprises a first opening overlapping the groove, and a second opening exposing a part of the p-type semiconductor layer, wherein
the light-emitting element further comprises a first electrode positioned in the second opening and connected to the p-type semiconductor layer.

7. The light-emitting element of any one of the preceding claims, further comprising a second electrode connected to the n-type semiconductor layer.

8. The light-emitting element of claim 7, further comprising a contact electrode disposed on the n-type semiconductor layer and connected between the n-type semiconductor layer and the second electrode.

9. The light-emitting element of claim 7 or 8, further comprising a second insulating layer disposed on the first insulating layer and surrounding a side surface of the n-type semiconductor layer.

10. The light-emitting element of claim 9, wherein the second electrode is disposed on the second insulating layer.

11. The light-emitting element of any one of the preceding claims, in which the groove comprises at least two grooves formed in the p-type semiconductor layer to be spaced apart from each other, the light-emitting layer comprises at least two light-emitting layers disposed in the at least two grooves to be spaced apart from each other; and
the n-type semiconductor layer comprises at least two n-type semiconductor layers disposed on the at least two light-emitting layers to be spaced apart from each other.

12. The light-emitting element of claim 11, wherein the first insulating layer comprises at least two openings corresponding to the at least two grooves, and surrounds an upper portion of each of the at least two light-emitting layers.

13. The light-emitting element of claim 12, further comprising a second insulating layer disposed on the first insulating layer, and surrounding side surfaces of the at least two n-type semiconductor layers.

14. A display device comprising a pixel comprising a first pixel electrode, a second pixel electrode, and a light-emitting element according to any one of the preceding claims connected between the first pixel electrode and the second pixel electrode.

15. A method of manufacturing a light-emitting element, comprising:
forming a p-type semiconductor layer on a substrate;
forming a first insulating layer on the p-type semiconductor layer;
forming a first opening in the first insulating layer to expose a part of the p-type semiconductor layer;
etching the part of the p-type semiconductor layer to a certain thickness to form a groove in the p-type semiconductor layer;
forming a light-emitting layer in the groove; and
forming an n-type semiconductor layer on the light-emitting layer.
